# EUROPEAN PATENT APPLICATION

(11) **EP 3 282 469 A2**
(43) Date of publication of application: **14.02.2018**
(21) Application number: 17185316.1
(22) Date of filing: 08.08.2017
(51) Int. Cl.: H01J 37/32, H01G 5/00, H03H 7/38, H03H 7/40

(54) **SYSTEMS AND METHODS FOR RF POWER RATIO SWITCHING FOR ITERATIVE TRANSITIONING BETWEEN ETCH AND DEPOSITION PROCESSES**

(30) Priority: 10.08.2016 US 201662373024 P
(71) Applicant: LAM Research Corporation, Fremont, CA 94538 (US)
(72) Inventor: SETTON, David, Danville, CA California 94526 (US); MAROHL, Daniel, San Jose, CA California 95132 (US); PENG, Shen, Dublin, CA California 94568 (US); BHATTACHARYYA, Gautam, San Ramon, CA California 94582 (US); KUTHI, Andras, Thousand Oaks, CA California 91320 (US)
(74) Representative: Kontrus, Gerhard

(57) **Abstract**

A system is provided and includes a first linear motor, a first separator support assembly, and a controller. The first linear motor includes a shaft that is linearly driven based on a current supplied to the first linear motor. The first separator support assembly is configured to connect to the shaft of the first linear motor and to a rod of a first capacitor of a match network. The first linear motor is configured to actuate the rod to move a first electrode of the first capacitor relative to a second electrode of the first capacitor to change a capacitance of the first capacitor. The controller is connected to the first linear motor and is configured to adjust power supplied to a first radio frequency reactor coil of a plasma processing chamber by adjusting the current supplied to the first linear motor.

## Description

### CROSS-REFERENCE TO RELATED APPLICATIONS

This application claims the benefit of U.S. Provisional Application No. 62/373,024, filed on August 10, 2016. The entire disclosure of the application referenced above is incorporated herein by reference.

### FIELD

The present disclosure relates to etching and deposition systems, and more particularly, to transformer coupled capacitive tuning systems.

### BACKGROUND

The background description provided here is for the purpose of generally presenting the context of the disclosure. Work of the presently named inventors, to the extent it is described in this background section, as well as aspects of the description that may not otherwise qualify as prior art at the time of filing, are neither expressly nor impliedly admitted as prior art against the present disclosure.

During manufacturing of semiconductor devices, etch processes and deposition processes may be performed within a processing chamber. Ionized gas, or plasma, can be introduced into the plasma chamber to etch (or remove) material from a substrate such as a semiconductor wafer, and to sputter or deposit material onto the substrate. Creating plasma for use in manufacturing or fabrication processes typically begins by introducing process gases into the processing chamber. The substrate is disposed in the processing chamber on a substrate support such as an electrostatic chuck or a pedestal.

The processing chamber may include transformer coupled plasma (TCP) reactor coils. A radio frequency (RF) signal, generated by a power source, is supplied to the TCP reactor coils. A dielectric window, constructed of a material such as ceramic, is incorporated into an upper surface of the processing chamber. The dielectric window allows the RF signal to be transmitted from the TCP reactor coils into the interior of the processing chamber. The RF signal excites gas molecules within the processing chamber to generate plasma.

The TCP reactor coils are driven by a transformer coupled capacitive tuning (TCCT) match network. The TCCT match network receives the RF signal supplied by the power source and enables tuning of power provided to the TCP reactor coils. The TCCT match network may include variable capacitors. Each of the variable capacitors includes a stationary electrode and a movable electrode. Position of the movable electrode relative to the stationary electrode is directly related to a capacitance of the corresponding capacitor. The movable electrodes can be connected to a leadscrew, which can be driven by a rotary motor.

Power supplied to each of the TCP reactor coils is based on positions of the movable electrodes of the capacitors. A ratio of power delivered to the TCP coils is also based on the positions of the movable electrodes of the capacitors. One or more power ratios provided during etching can be different than one or more power ratios provided during deposition.

### SUMMARY

A system is provided and includes a first linear motor, a first separator support assembly, and a controller. The first linear motor includes a shaft that is linearly driven based on a current supplied to the first linear motor. The first separator support assembly is configured to connect to the shaft of the first linear motor and to a rod of a first capacitor of a match network. The first linear motor is configured to actuate the rod to move a first electrode of the first capacitor relative to a second electrode of the first capacitor to change a capacitance of the first capacitor. The controller is connected to the first linear motor and is configured to adjust power supplied to a first radio frequency reactor coil of a plasma processing chamber by adjusting the current supplied to the first linear motor.

The system may further comprise the match network comprising the first capacitor, wherein the match network is configured to receive a radio frequency signal from a power source, and the first radio frequency reactor coil configured to receive the radio frequency signal from the match network and transmit the radio frequency signal into the plasma processing chamber based on the capacitance of the first capacitor. In this case the match network may be a transformer coupled capacitive tuning match network.

The system my further comprise a second separator support assembly configured to connect to the shaft of the first linear motor and to a second rod of a second capacitor of the match network, wherein the first linear motor is configured to actuate the second rod to move a first electrode of the second capacitor relative to a second electrode of the second capacitor to change a capacitance of the second capacitor; and the controller is configured to adjust power supplied to a second radio frequency reactor coil of the plasma processing chamber by adjusting the current supplied to the first linear motor.

In this case the controller may be configured to iteratively switch between a first radio frequency power ratio and a second radio frequency power ratio by adjusting the current supplied to the first linear motor; and the first radio frequency power ratio and the second radio frequency power ratio are ratios of an amount of power supplied to the first radio frequency reactor coil relative to an amount of power supplied to the second radio frequency reactor coil. In this instance the controller is configured to select the first radio frequency power ratio for etch processing, to select the second radio frequency power ratio for deposition processing, and to iteratively switch between (i) performing a selected one of a plurality of etch processes and (ii) performing a selected one of a plurality of deposition processes, wherein performance of each of the plurality of etch processes includes etch processing, and wherein performance of each of the plurality of deposition processes includes deposition processing.

The system of may comprise the first capacitor; and the second capacitor, wherein the second capacitor counterbalances a force exerted on the shaft of the first linear motor by the first capacitor. In this instance an amount of the force exerted on the shaft of the first linear motor by the first capacitor may be different than an amount of force exerted on the shaft by the second capacitor.

The system may alternatively further comprise a second linear motor comprising a shaft that is linearly driven based on a current supplied to the second linear motor; and a second separator support assembly configured to connect to the shaft of the second linear motor and to a second rod of a second capacitor of the match network, wherein the second linear motor is configured to actuate the second rod to move a first electrode of the second capacitor relative to a second electrode of the second capacitor to change a capacitance of the second capacitor, the controller is connected to the second linear motor and configured to adjust power supplied to a second radio frequency reactor coil of the plasma processing chamber by adjusting the current supplied to the second linear motor.

The controller may be configured to iteratively switch between a first radio frequency power ratio and a second radio frequency power ratio by adjusting the current supplied to the first linear motor and the current supplied to the second linear motor; and the first radio frequency power ratio and the second radio frequency power ratio are ratios of an amount of power supplied to the first radio frequency reactor coil relative to an amount of power supplied to the second radio frequency reactor coil.

The system may further comprise the first radio frequency reactor coil and the second radio frequency reactor coil.

A counterbalance assembly may be connected to the first linear motor and configured to counterbalance forces exerted on the shaft by the first capacitor. In this instance advantageously the first capacitor is a variable vacuum capacitor; and the first capacitor resists movement of the first electrode away from the second electrode and in a direction away from the first linear motor.

In other features, a system is provided and includes a first cam follower, a first cam, a first rotary motor, a first separator support assembly, and a controller. The first cam includes a slot. The slot has a predetermined path. The first cam follower is disposed at least partially within the slot and follows the predetermined path. The first rotary motor is connected to the first cam and configured to be driven based on a current supplied to the first rotary motor. The first rotary motor is configured to rotate the first cam causing the first cam follower to move along the predetermined path. The first separator support assembly is configured to connect to the first cam follower and a rod of a first capacitor of a match network. Rotation of the cam and movement of the cam follower actuates the rod and moves a first electrode relative to a second electrode of the first capacitor to change a capacitance of the first capacitor. The controller is connected to the first rotary motor and configured to adjust power supplied to a first radio frequency reactor coil of a plasma processing chamber by adjusting the current supplied to the first rotary motor.

The first rotary motor may comprise a shaft; the shaft being connected to the first cam; and the rotary motor being configured to rotate the shaft causing the first cam to rotate and the first cam follower to move along the predetermined path.

The first cam may be connected to a support bracket; and the first cam may be configured to rotate relative to the support bracket.

The support bracket may comprise a stop element; and the first cam may be prevented from rotating in a predetermined direction when the first cam is in contact with the stop element.

The support bracket may comprise a first stop element, the first cam comprise a second stop element; and the first cam may be prevented from rotating in a predetermined direction when the second stop element of the first cam is in contact with the first stop element of the support bracket.

Alternatively this system, further comprises a counterbalance assembly connected to the rotary motor or the cam and configured to counterbalance resistance of movement of the first electrode. In this case the first capacitor may be a variable vacuum capacitor that is configured to provide the resistance of the movement of the first electrode.

Alternatively this system, further comprises a second cam follower, a second cam comprising a slot, wherein the slot of the second cam has a second predetermined path, and wherein the second cam follower is disposed at least partially within the slot of the second cam and follows the second predetermined path, a second rotary motor connected to the second cam and configured to be driven based on a current supplied to the second rotary motor, wherein the second rotary motor is configured to rotate the second cam causing the second cam follower to move along the second predetermined path, and a second separator support assembly configured to connect to the second cam follower and a rod of a second capacitor of the match network, wherein rotation of the second cam and movement of the second cam follower actuates the rod of the second capacitor and moves the first electrode of the second capacitor relative to a second electrode of the second capacitor to change a capacitance of the second capacitor, and wherein the controller is connected to the second rotary motor and is configured to adjust power supplied to a second radio frequency reactor coil of the plasma processing chamber by adjusting the current supplied to the second rotary motor.

In this instance, the controller may be configured to iteratively switch between a first radio frequency power ratio and a second radio frequency power ratio by adjusting the current supplied to the first rotary motor and the current supplied to the second rotary motor; and the first radio frequency power ratio and the second radio frequency power ratio are ratios of an amount of power supplied to the first radio frequency reactor coil relative to an amount of power supplied to the second radio frequency reactor coil. The controller may be configured to select the first radio frequency power ratio for etch processing, to select the second radio frequency power ratio for deposition processing, and to iteratively switch between (i) performing a selected one of a plurality of etch processes and (ii) performing a selected one of a plurality of deposition processes, wherein performance of each of the plurality of etch processes includes etch processing, and wherein performance of each of the plurality of deposition processes includes deposition processing.

In other features, a system is provided and includes a leadscrew, a first rotary motor, a first separator support assembly, a counterbalance assembly and a controller. The leadscrew is connected to a first electrode of a first capacitor of a match network. The first rotary motor is connected to and configured to rotate the leadscrew based on a current supplied to the first rotary motor. The first separator support assembly is configured to connect to the leadscrew and to a shaft of the first rotary motor. The first rotary motor is configured to rotate the leadscrew to move the first electrode relative to a second electrode of the first capacitor to change a capacitance of the first capacitor. The counterbalance assembly is connected to the shaft of the first rotary motor and is configured to counterbalance forces on the leadscrew by the first capacitor. The controller is connected to the first rotary motor and configured to adjust power supplied to a first radio frequency reactor coil of a plasma processing chamber by adjusting the current supplied to the first rotary motor.

A pitch of the leadscrew may be such that the leadscrew has less than or equal to 6 revolutions per inch of travel.

The system may further comprise a second separator support assembly configured to connect to the shaft of the first rotary motor and to a second leadscrew of a second capacitor of the match network, wherein: the first rotary motor is configured to move a first electrode of the second capacitor relative to a second electrode of the second capacitor to change a capacitance of the second capacitor; and wherein the controller is configured to adjust power supplied to a second radio frequency reactor coil of the plasma processing chamber by adjusting the current supplied to the first rotary motor.

The controller may be configured to iteratively switch between a first radio frequency power ratio and a second radio frequency power ratio by adjusting the current supplied to the first rotary motor; and the first radio frequency power ratio and the second radio frequency power ratio are ratios of an amount of power supplied to the first radio frequency reactor coil relative to an amount of power supplied to the second radio frequency reactor coil.

The system may further comprise the first capacitor; and the second capacitor, wherein the second capacitor counterbalances a force exerted on the shaft of the first rotary motor by the first capacitor. An amount of the force exerted on the shaft of the first rotary motor by the first capacitor may be different than an amount of force exerted on the shaft by the second capacitor.

The system may further comprise: a second leadscrew; a second rotary motor connected to and configured to rotate the second leadscrew based on a current supplied to the second rotary motor; a second separator support assembly configured to connect to the second leadscrew and to a second shaft of the second rotary motor, wherein the second rotary motor is configured to move a first electrode of a second capacitor of the match network relative to a second electrode of the second capacitor to change a capacitance of the second capacitor; and a second counterbalance assembly connected to the second rotary motor and configured to counterbalance forces on the second shaft by the second capacitor, wherein the second rotary motor is configured to move the first electrode of the second capacitor relative to a second electrode of the second capacitor to change a capacitance of the second capacitor, and the controller is connected to the second rotary motor and configured to adjust power supplied to a second radio frequency reactor coil of the plasma processing chamber by adjusting the current supplied to the second rotary motor.

The controller may be configured to iteratively switch between a first radio frequency power ratio and a second radio frequency power ratio by adjusting the current supplied to the first rotary motor and the current supplied to the second rotary motor; and the first radio frequency power ratio and the second radio frequency power ratio may be ratios of an amount of power supplied to the first radio frequency reactor coil relative to an amount of power supplied to the second radio frequency reactor coil.

The controller may be configured to select the first radio frequency power ratio for etch processing, to select the second radio frequency power ratio for deposition processing; and to iteratively switch between (i) performing a selected one of a plurality of etch processes and (ii) performing a selected one of a plurality of deposition processes, wherein performance of each of the plurality of etch processes includes etch processing, and wherein performance of each of the plurality of deposition processes includes deposition processing.

In yet other features, a system is provided and includes a match network, a first one or more switches, a second one or more switches, and a controller. The match network includes a first capacitor, a second capacitor, a third capacitor, and a fourth capacitor. The first one or more switches is configured to supply power from a power input circuit to the first capacitor and the second capacitor. The second one or more switches is configured to supply power from the power input circuit to the third capacitor and the fourth capacitor. The controller is configured to: (i) control states of the first one or more switches and the second one or more switches to switch between providing a first ratio of power and a second ratio of power; (ii) provide the first ratio of power to a first radio frequency reactor coil and a second radio frequency reactor coil of a plasma processing chamber by activating the first one or more switches; and (iii) provide the second ratio of power to the first radio frequency reactor coil and the second radio frequency reactor coil by activating the second one or more switches.

The first one or more switches may comprise only a first switch configured to supply power from the power input circuit to the first capacitor and the second capacitor; and the second one or more switches comprises only a second switch configured to supply power from the power input circuit to the third capacitor and the fourth capacitor.

The first one or more switches may comprise a first switch and a second switch wherein, the first switch supplies power from the power input circuit to the first capacitor; the second switch supplies power from the power input circuit to the second capacitor; the second one or more switches comprise a third switch and a fourth switch; the third switch supplies power from the power input circuit to the third capacitor; and the fourth switch supplies power from the power input circuit to the fourth capacitor.

The controller may configured to activate the first one or more switches during etch processing; to activate the second one or more switches during deposition processing; and to iteratively switch between (i) performing a selected one of a plurality of etch processes and (ii) performing a selected one of a plurality of deposition processes, wherein performance of each of the plurality of etch processes includes etch processing, and wherein performance of each of the plurality of deposition processes includes deposition processing.

The controller may be configured to deactivate the second one or more switches during etch processing; and to deactivate the first one or more switches during deposition processing.

The controller may be configured to change the selected one of the plurality of etch processes to a different one of the plurality of etch processes while iteratively switching between (i) performing the selected one of the plurality of etch processes and (ii) performing the selected one of the plurality of deposition processes; and to change the selected one of the plurality of deposition processes to a different one of the plurality of deposition processes while iteratively switching between (i) performing the selected one of the plurality of etch processes and (ii) performing the selected one of the plurality of deposition processes.

In this case the controller may be configured to change capacitances of the first capacitor and the second capacitor when changing between the plurality of etch processes; and to change capacitances of the third capacitor and the fourth capacitor when changing between the plurality of deposition processes.

The system may further comprise an inner coil output circuit comprising an inductor connected (i) at a first end to the first radio frequency reactor coil, and (ii) at a second end to a reference terminal; and an outer coil output circuit comprising a fifth capacitor connected (i) at a first end to the second radio frequency reactor coil, wherein a first end of the first radio frequency reactor coil is connected to the first capacitor and the third capacitor, a second end of the first radio frequency reactor coil is connected to the inner coil output circuit; a first end of the second radio frequency reactor coil is connected to the second capacitor and the fourth capacitor; and the second end of the second radio frequency reactor coil is connected to the outer coil output circuit.

### BRIEF DESCRIPTION OF THE DRAWINGS

The present disclosure will become more fully understood from the detailed description and the accompanying drawings, wherein:
FIG. 1 is a functional block diagram of an example of a plasma processing system incorporating an RF power ratio switching system in accordance with the present disclosure;
FIG. 2 is a schematic view of an example of a TCCT match network and a corresponding capacitance adjustment system in accordance with the present disclosure;
FIG. 3 is a functional block diagram of an example of a TCCT match network including variable capacitors and inner coil circuits and outer coil circuits in accordance with the present disclosure;
FIG. 4 is a schematic diagram of the TCCT match network of FIG. 3;
FIG. 5 is a side perspective view of an example of a dual capacitor system including a single linear motor in accordance with the present disclosure;
FIG. 6 is a side cross-sectional view of the dual capacitor system of FIG. 5;
FIG. 7 is a side perspective view of an example of a single capacitor system including a single linear motor and a counterbalance assembly in accordance with the present disclosure;
FIG. 8 is a side cross-sectional view of the single capacitor system of FIG. 7;
FIG. 9 is a perspective view of an example of a single capacitor including a single rotary motor and a cam in accordance with the present disclosure;
FIG. 10 is another perspective view of the single capacitor system of FIG. 9;
FIG. 11 is a side cross-sectional view of the single capacitor system of FIGs. 9-10;
FIGs. 12A-12C are side perspective views of a portion of the single capacitor system of FIGs. 9-11 illustrating cam movement;
FIG. 13 is a side perspective view of a single capacitor system including a single rotary motor and a counterbalance assembly in accordance with the present disclosure;
FIG. 14 is a side cross-sectional view of the single capacitor system of FIG. 13.
FIG. 15 is a cross-sectional view of a vacuum variable capacitor that may be used in the embodiments of FIGs. 1-14;
FIG. 16 is a schematic diagram of another example of a TCCT match network including a shared switch for each set of etch and deposition capacitors in accordance with an embodiment of the present disclosure; and
FIG. 17 is a schematic diagram of another example of a TCCT match network including a switch for each etch capacitor and deposition capacitor in accordance with an embodiment of the present disclosure.

In the drawings, reference numbers may be reused to identify similar and/or identical elements.

### DETAILED DESCRIPTION

A traditional TCCT match network may include two variable capacitors; one capacitor for each TCP reactor coil of a processing chamber. Each of the capacitors includes stationary electrodes and movable electrodes. The TCP reactor coils may include an inner coil and an outer coil. The inner coil is disposed within an outer coil. A ratio of power supplied to the inner coil relative to power supplied to the outer coil is adjusted by moving the moveable electrodes of the capacitors. The moveable electrodes may be moved via respective leadscrews and rotary motors. This technique for moving the moveable electrodes is too slow for a rapid alternating process (RAP), which includes rapidly switching between etch and deposition processes. The duration of each etch process and each deposition process may be 1 second or less.

An example speed requirement of a RAP is to provide RF power ratio switching of 10-90% in less than 100 milli-seconds (ms). RF power ratio switching of 10-90% includes switching from providing 10% power via a first capacitor and 90% power via a second capacitor to providing 90% power via the first capacitor to 10% power via the second capacitor. The traditional method of moving moveable electrodes via respective leadscrews and rotary motors is not capable of satisfying the stated speed requirement.

Examples are described below that allow for quick movement of movable electrodes of capacitors of a TCCT match network. This allows for fast RF power ratio switching to satisfy RAP speed requirements of, for example, a deep silicon etch (DSiE) process and thus fast transitioning between etch and deposition processes. The disclosed examples provide RF power ratio switching of 10-90% in less than 100 milli-seconds (ms). The quick transitioning allows for chemistries within a processing chamber to be quickly changed for etch and deposition processing, which allows for controlling and providing different uniformity patterns on a wafer. Etch processes are typically "edge fast" meaning etching occurs at a quicker rate near an edge of a substrate than near a center of a substrate. Deposition processes are typically "center fast" meaning material is deposited on a substrate at a quicker rate near a center of the substrate than near an edge of the substrate. The fast RF power ratio switching allows the uniformity patterns of the etch and deposition processes to be better controlled.

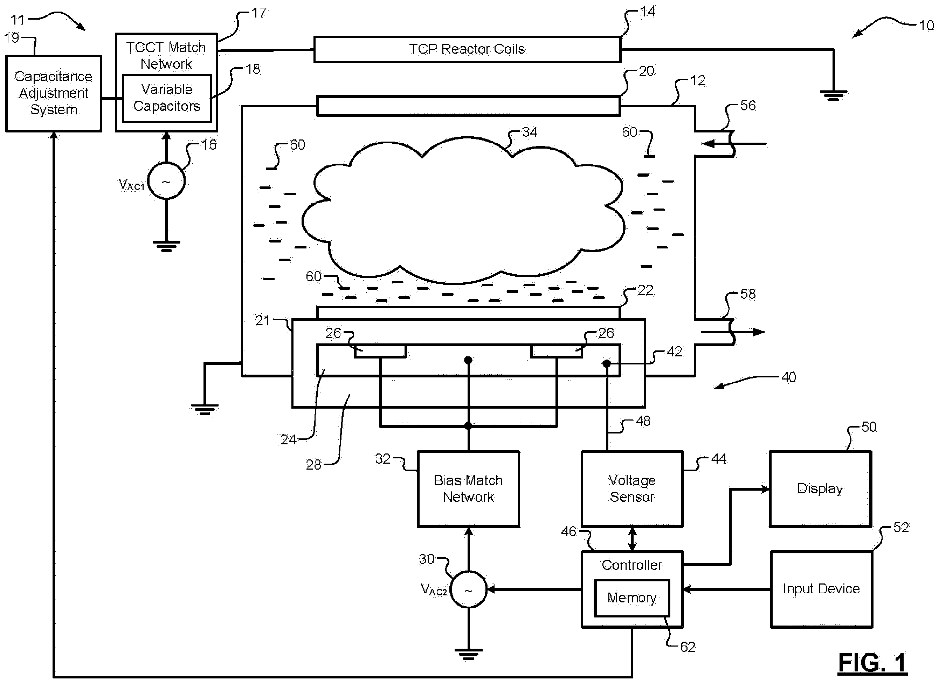

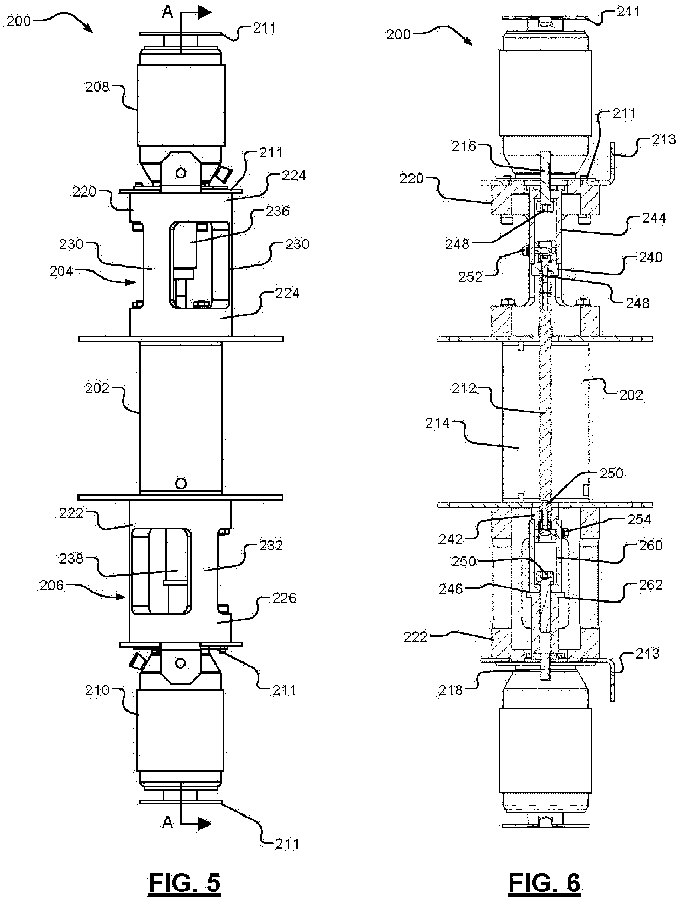

FIG. 1 shows a plasma processing system 10 that includes a RF power ratio switching system 11, a plasma processing chamber 12, a controller 13 and TCP reactor coils 14. The RF power ratio switching system 10 switches RF power ratios of the TCP reactor coils 14. The TCP reactor coils 14 are disposed outside and above the plasma processing chamber 12. The first power source 16 provides a first RF source signal. A TCCT (or first) match network 17 is included between the first power source 16 and the TCP reactor coils 14. The TCCT match network 17 enables tuning of power provided to the TCP reactor coils 14. The TCCT match network 17 includes variable capacitors 18, which are adjusted via the RF power ratio switching system 11. The RF power ratio switching system 11 includes a capacitance adjustment system 19 and the controller 13. Examples of the capacitance adjustment system 19 are shown in FIGs. 5-14. The capacitance adjustment system 19 may include motors (examples of which are shown in FIGs. 5-14), which are controlled by the controller 13. The controller 13 adjusts the capacitances of the capacitors 18 to adjust a RF power ratio of power supplied to the TCP reactor coils 14.

The plasma processing chamber 12 includes a ceramic window 20, which is located adjacent the TCP reactor coils 14 and allows efficient transmission of the first RF source signal into the plasma processing chamber 12 for plasma generation purposes. A substrate support 21 such as an electrostatic chuck, a pedestal or other suitable substrate support is disposed at the bottom of the plasma processing chamber 12. The substrate support 21 supports a substrate 22. If the substrate support 21 is an electrostatic chuck, the substrate support 21 includes electrically conductive portions 24 and 26, which are electrically isolated from each other. The substrate support 21 is surrounded by an insulator 28 and is capacitively coupled to the substrate 22. By applying a DC voltage across the conductive portions 24, 26, an electrostatic coupling is created between the conductive portions 24, 26 and the substrate 22. This electrostatic coupling attracts the substrate 22 against the substrate support 21.

The plasma processing system 10 further includes a bias RF power source 30, which is connected to a bias (or second) match network 32. The second match network 32 is connected between the bias RF power source 30 and the substrate support 21. The second match network 32 matches an impedance (e.g., 50Ω) of the bias RF power source 30 to an impedance of the substrate support 21 and plasma 34 in the plasma processing chamber 12 as seen by the second matching network 32.

The plasma processing system 10 further includes a voltage control interface (VCI) 40. The VCI 40 may include a pickup device 42, a voltage sensor 44, a controller 13 and circuits between the voltage sensor 44 and the controller 13. The pickup device 42 extends into the substrate support 21. This pickup device 42 is connected via a conductor 48 to the voltage sensor 44 and is used to generate a RF voltage signal.

Operation of the voltage sensor 44 may be monitored, manually controlled, and/or controlled via the controller 13. The controller 13 may display output voltages of the channels of the voltage sensor 44 on a display 50. Although shown separate from the controller 13, the display 50 may be included in the controller 13. A system operator may provide input signals indicating (i) whether to switch between the channels, (ii) which one or more of the channels to activate, and/or (ii) which one or more of the channels to deactivate.

In operation, a gas capable of ionization flows into the plasma processing chamber 12 through the gas inlet 56 and exits the plasma processing chamber 12 through the gas outlet 58. The first RF signal is generated by the RF power source 16 and is delivered to the TCP reactor coil 14. The first RF signal radiates from the TCP reactor coil 14 through the window 20 and into the plasma processing chamber 12. This causes the gas within the plasma processing chamber 12 to ionize and form the plasma 34. The plasma 34 produces a sheath 60 along walls of the plasma processing chamber 12. The plasma 34 includes electrons and positively charged ions. The electrons, being much lighter than the positively charged ions, tend to migrate more readily, generating DC bias voltages and DC sheath potentials at inner surfaces of the plasma processing chamber 12. An average DC bias voltage and a DC sheath potential at the substrate 22 affects the energy with which the positively charged ions strike the substrate 22. This energy affects processing characteristics such as rates at which etching or deposition occurs.

The controller 13 may adjust the bias RF signal generated by the RF power source 30 to change the amount of DC bias and/or a DC sheath potential at the substrate 22. The controller 13 may compare outputs of the channels of the voltage sensor 44 and/or a representative value derived based on the outputs of the channels to one or more set point values. The set point values may be predetermined and stored in a memory 62 of the controller 13. The bias RF signal may be adjusted based on differences between (i) the outputs of the voltage sensor 44 and/or the representative value and (ii) the one more set point values. The bias RF signal passes through the second match network 32. An output provided by the second match network 32 (referred to as a matched signal) is then passed to the substrate support 21. The bias RF signal is passed to the substrate 22 through the insulator 28.

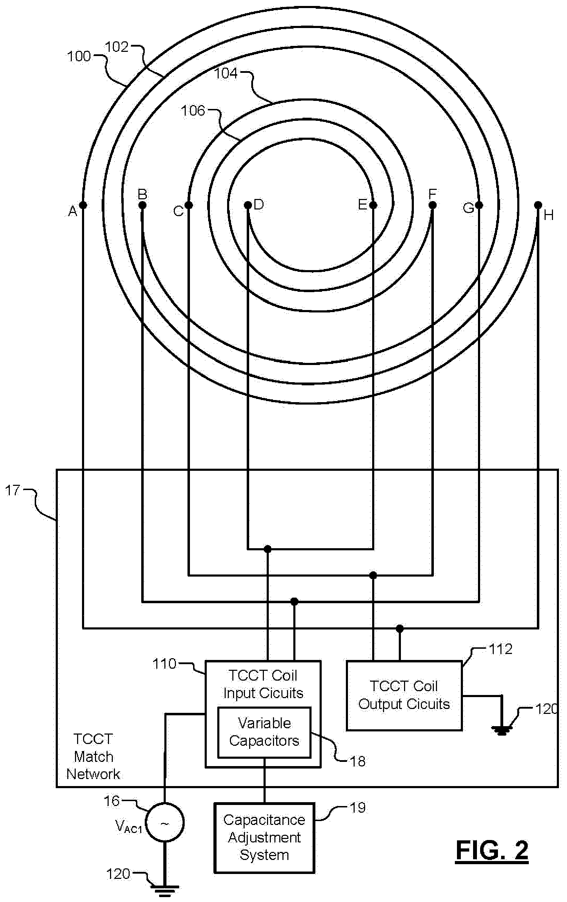

FIG. 2 shows an example of the TCCT match network 17 connected to examples TCP reactor coils 100, 102, 104, 106. The TCP reactor coils 100, 102 are collectively referred to as an outer coil. The TCP reactor coils 104, 106 are collectively referred to as an inner coil. The outer coil and inner coil may be spiral-shaped as shown or may have a different shape and/or configuration. The TCCT match network 17 includes TCCT coil input circuits 110 and TCCT coil output circuits 112. The TCCT coil input circuits 110 are connected to the inner coil at coil ends D and E and to the outer coil at coil ends B and G. The TCCT coil output circuits 112 are connected to the inner coil at coil ends C and F and to the outer coil at coil ends A and H. The TCCT coil input circuits 110 receive power from the power source 16, which is connected to a reference terminal (or ground reference) 120. The TCCT coil output circuits 112 are connected to the reference terminal 120.

The TCCT coil input circuits 110 include the variable capacitors 18, which when adjusted adjust power supplied from the TCCT coil input circuits 110 to the inner coil and the outer coil, respectively. This adjusts a RF power ratio between the inner coil and the outer coil. The capacitance adjustment system 19 is connected to the variable capacitors 18.

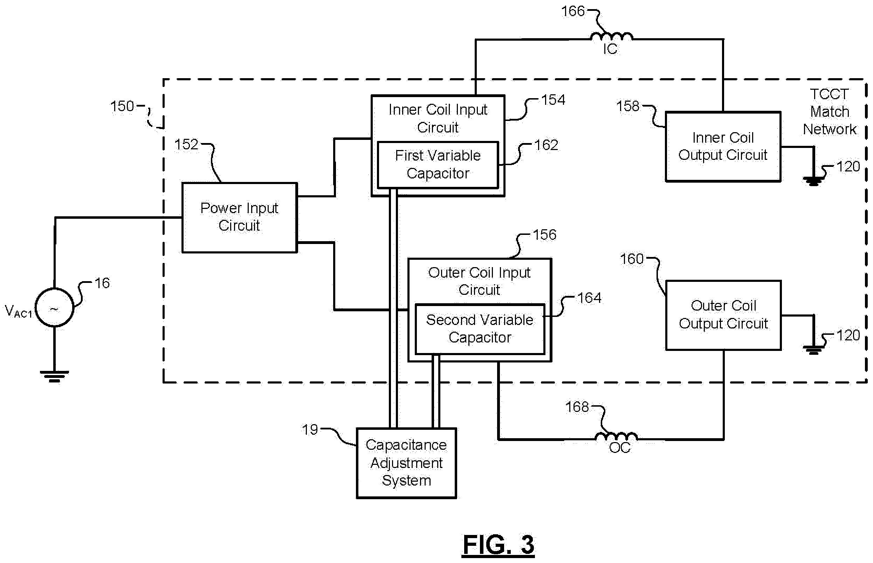

FIG. 3 shows a TCCT match network 150 that may replace the TCCT match network 17 of FIGs. 1-2. The TCCT match network 150 receives power from the power source 16. The TCCT match network 150 includes a power input circuit 152, an inner coil input circuit 154, an outer coil input circuit 156, an inner coil output circuit 158, and an outer coil output circuit 160. The coil input circuits 154, 156 include a first variable capacitor 162 and a second variable capacitor 164 and provide power to an inner coil IC 166 and an outer coil OC 168. Power out of the coils 166, 168 is provided to the coil output circuits 158, 160, which are connected to the reference terminal 120. The variable capacitors 162, 164 are adjusted by the capacitance adjustment system 19.

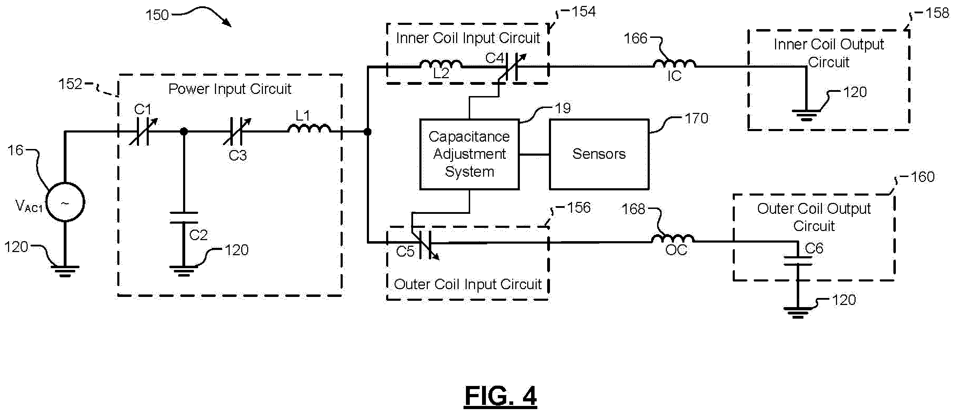

FIG. 4 shows an example of the TCCT match network 150 of FIG. 3. The TCCT match network 150 receives power from the power source 16. The TCCT match network 150 includes the power input circuit 152, the inner coil input circuit 154, the outer coil input circuit 156, the inner coil output circuit 158, and the outer coil output circuit 160. The power input circuit 152 may include a first capacitor C1, a second capacitor C2, a third capacitor C3 and an inductor L1. The capacitors C1 and C3 may be variable capacitors. The capacitors C1, C3 and inductor L1 are connected in series between the power source 16 and the coil input circuits 154, 156. The capacitor C2 is connected (i) at a first end to an output of the capacitor C1 and an input of the capacitor C3, and (ii) at a second end to the reference terminal 120.

The inner coil input circuit 154 may include a second inductor L2 and a fourth capacitor C4. The inductor L2 and capacitor C4 are connected in series between the inductor L1 and the inner coil 166. The outer coil input circuit 156 may include a fifth capacitor C5. The capacitor C5 is connected at a first end to the inductor L1 and at a second end to the outer coil 168. The capacitors C4 and C5 are variable capacitors, which are adjusted by the capacitance adjustment system 19.

The inner coil output circuit 158 may include the reference terminal 120, which is connected to an output of the inner coil 166. The outer coil output circuit 160 may include a sixth capacitor C6, which is connected at a first end to the outer coil 168 and at a second end to the reference terminal 120.

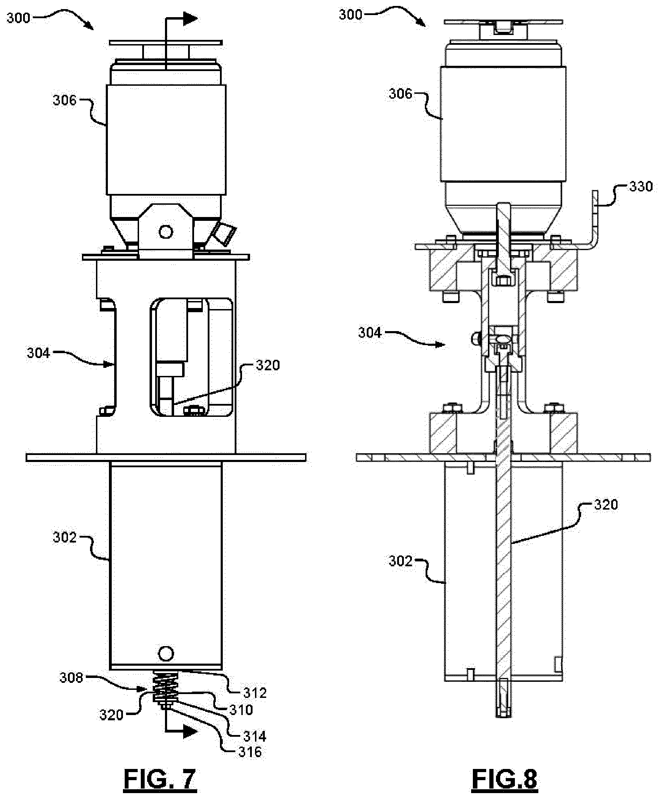

Examples of devices and components that may be included in the capacitance adjustment system 19 and examples of the variable capacitors C4 and C5 are shown in FIGs. 5-14. The capacitors C4, C5 may be included in a dual capacitor assembly (e.g., dual capacitor assembly of FIGs. 5-6) or in separate single capacitor assemblies (e.g., the single capacitor assemblies of FIGs. 7-14. The capacitance adjustment system 19 may include one of the dual capacitor assemblies, two of the single capacitor assemblies and the corresponding devices, components, motors, shafts, counterbalance assemblies, cams, cam followers, etc. The capacitance adjustment system 19 may include linear and/or rotary motors that are controlled by the controller 46 of FIG. 1. The motors are used to adjust capacitance of the capacitors C4, C5. Examples of the capacitors is shown in FIGs. 5-15.

The capacitive adjustment system 19 may include sensors 170 (e.g., potentiometers, encoders, etc.) for detecting positions of one or more shafts and/or rods of motors and capacitors (e.g., capacitors C4, C5). The sensors 170 may be included in the motors, on the motors, and/or connected directly and/or indirectly to the shafts and/or rods. The controller 46 of FIG. 1 may adjust voltage, current and/or power supplied to the motors to adjust position of the shafts and/or rods based on signals received from the sensors 170.

FIGs. 5-6 show a dual capacitor system 200 including a single linear motor 202, separator support assemblies 204, 206, and capacitor 208, 210. The linear motor 202 may be a voice coil derivative type motor or other suitable linear motor. The linear motor 202 includes a shaft 212 that extends through a housing 214 of the linear motor 202 and is connected to rods 216, 218 of the capacitors 208, 210 via the separator support assemblies 204, 206. The linear motor 202, based on a control signal received from the controller 46 of FIG. 1, moves the rods 216, 218 to change capacitances of the capacitors 208, 210.

The separator support assemblies 204, 206, as shown, include stand-off members 220, 222, which are cylindrically-shaped. The stand-off members 220, 222 may include pairs of end rings 224, 226 that are connected to each other via connecting members 230, 232 providing holes through which flexible couplings 236, 238 can be seen. The stand-off members 220, 222 may be formed of insulative material and provide separation between the linear motor 202 and the capacitors 208, 210. This prevents high-voltages and/or current received by the capacitors 208, 210 from being received by and/or interfering with operation of the linear motor 202.

The flexible couplings 236, 238 allow for axial and/or radial misalignment of the shaft 212 relative to the rods 216, 218. The flexible couplings 236, 238 may be formed of an insulative material. Although flexible couplings 236, 238 are described, fixed couplings, which do not allow for axial and/or radial misalignment of the shaft 212 and the rods 216, 218 may be used. The flexible couplings 236, 238 include respective inner couplings 240, 242, outer couplings 244, 246, coupling fasteners 248, 250 (e.g., screws), and center fasteners 252, 254 (e.g., screws). The inner couplings 240, 242 are connected to the shaft 212 of the linear motor 202 via corresponding ones of the coupling fasteners 248, 250 (or inner coupling fasteners). The outer couplings 244, 246 are connected to the rods 216, 218 of the capacitors 208, 210 via other ones of the coupling fasteners 248, 250 (or outer coupling fasteners). In one embodiment, at least a portion of the inner couplings 240, 242 are screwed into at least a portion of the outer couplings 244, 246. In an embodiment, the center fasteners 252, 254 connect the outer couplings 244, 246 to the inner couplings 240, 242 and prevent the outer couplings 244, 246 from moving relative to the inner couplings 244, 242.

The outer couplings 244, 246 (e.g., the outer coupling 246 as shown) may include an intermediary member 260 and an outer member 262. The outer member 262 is connected to the rod 218. The intermediary member 260 connects the inner coupling 242 to the outer member 262. The fastener 250 connects the intermediary member 260 and the outer member 262 to the rod 218.

The capacitors 208, 210 include terminals 211 (an input terminal and an output terminal). The input terminals receive RF power from, for example, inductors L1, L2 of FIG. 4. One of the terminals 211 of each of the capacitors 208, 210 is connected to a corresponding one of RF brackets 213. The RF power is provided from the output terminals to the coil output circuits 158, 160 of FIG. 4. The input terminals or the output terminals may receive the RF power, depending on the implementation.

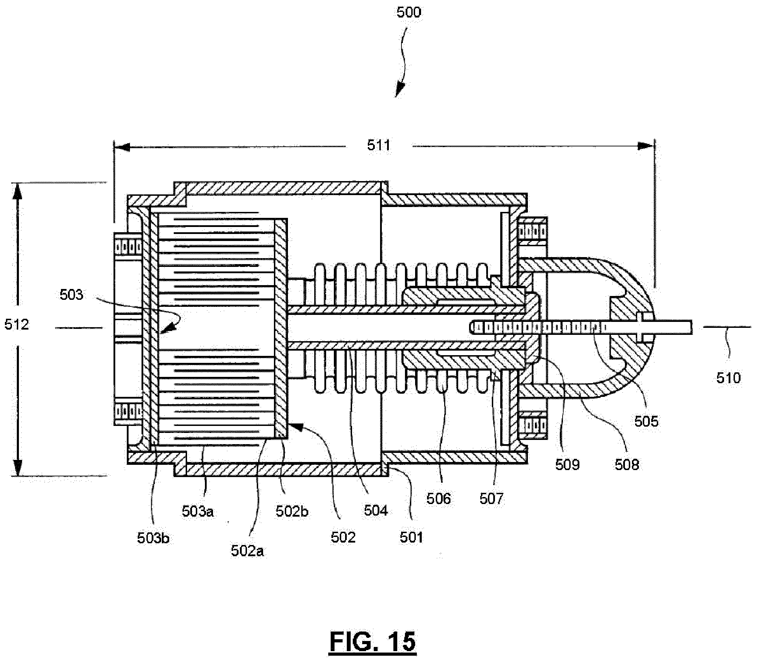

In one embodiment, the capacitors 208, 210 are variable vacuum capacitors (e.g., a variable vacuum capacitor is shown in FIG. 15). The capacitors 208, 210 include the rods 216, 218, which are biased towards the capacitors 208, 210. For example, the capacitors 208, 210 are configured such that there is a constant force applied on the rods 216, 218 in an inward direction away from the linear motor 202. The constant force is provided by vacuum pressure within the capacitors 208, 210 and spring-based force provided by bellows within the capacitors 208, 210. As an example, the force to pull one of the rods 216, 218 out of one of the capacitors 208, 210 may be 15 pounds (lbs.) per square inch (psi). Since the capacitors 208, 210 are connected on opposite sides of the shaft 212, the forces applied on the rods 216, 218 counterbalance each other to allow easy movement of the shaft 212 and the rods 216, 218 via the linear motor 202.

The embodiment of FIGs. 5-6 allows for a single linear motor to actuate rods of multiple capacitors. Actuation of the rods causes first electrodes within the capacitors to move relative to other electrodes within the capacitors, thereby, changing capacitances of the capacitors. Example electrodes of a capacitor are shown in FIG. 15. The capacitors counterbalance each other without the need for other counterbalances. The forces of the capacitors on the rods and shaft of the linear motor effectively cancel each other to allow for the rods and shaft to be easily and quickly actuated. This reduces size and power requirements of the linear motor and/or allows for the linear motor to actuate the rods and shaft at high speeds for RAP and/or high-speed switching between RF power ratios of TCP reactor coils.

As shown, the linear motor 202 displaces the rods in opposite directions relative to the capacitors. For example, as one rod is being pulled out of one of the capacitors, the other rod is being pushed into the other capacitor. This is different than the embodiments of FIGs. 7-14, which allow for independent actuation of the rods of capacitors.

FIGs. 7-8 show a single capacitor system 300 including a single linear motor 302, a separator support assembly 304, a capacitor 306 and a counterbalance assembly 308. The counterbalance assembly 308 is shown in FIG. 7 and not in FIG. 8. This arrangement may be provided for each variable capacitor of a plasma processing system, where actuation of a rod of the capacitor is utilized. As a result, a linear motor is provided for each capacitor. Unlike the embodiment of FIGs. 5-6, the embodiment of FIGs. 7-8 allows for independent actuation of the rods of the capacitors by providing a linear motor for each capacitor. Also, the forces on the rod of each of the capacitors are counterbalanced by a counterbalance assembly (e.g., the counterbalance assembly 308), which is connected on an opposite end of a shaft of the linear motor than the capacitor and separator support assembly. The separator support assembly 304 is configured similarly to the separator support assemblies 204, 206 of FIGs. 5-6.

In the embodiment shown, the counterbalance assembly 308 may include a spring 310 and spring retainers 312, 314. The spring 310 is a compression spring and is held between the spring retainers 312, 314. A fastener 316 (e.g., a screw) connects the counterbalance assembly 308 to the linear motor 302. In the example shown, the fastener 316 is a screw that is inserted through the end most one of the spring retainers (e.g., spring retainer 314) and is screwed into an end of a shaft 320 of the linear motor 302 to hold the spring 310 and spring retainers 312, 314 to the linear motor 302.

The counterbalance assembly 308 counterbalances a predetermined amount of the forces of the capacitor 306 on a rod 330 of the capacitor 306. In one embodiment, the counterbalance assembly 308 counterbalances 90% of the forces of the capacitor 306 on the rod 330. In this manner, the rod 330 is biased to be pulled into the capacitor 306. This maintains some tension on the rod 330 and prevents the rod 330 from floating, which maintains accuracy in setting position of the rod 330 and thus capacitance of the capacitor 306.

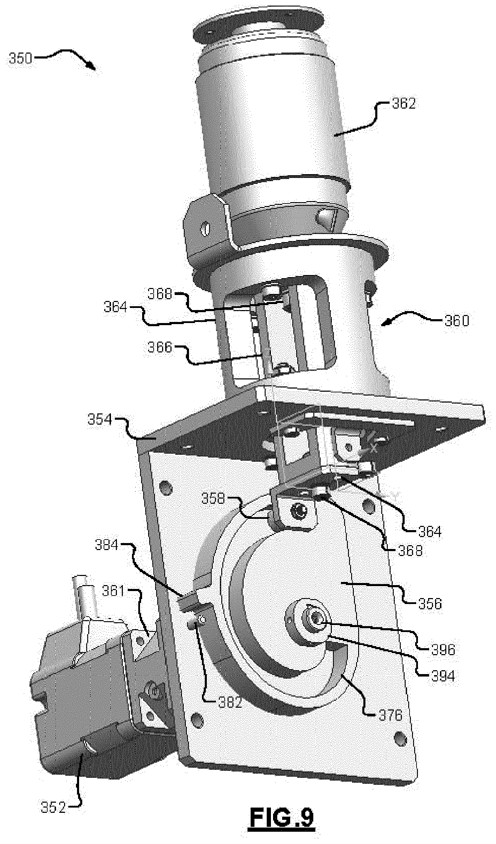

FIGs. 9-12C show a single capacitor system 350 including a single rotary motor 352, a support bracket 354, a cam 356, a cam follower 358, a separator support assembly 360 and a capacitor 362. The support bracket 354, as shown, is 'L'-shaped and holds the separator support assembly 360 in a fixed location relative to the rotary motor 352. The rotary motor 352 may include a gearbox 361. The separator support assembly 360 includes a stand-off member 364 and an inner coupling 366. The inner coupling 366 is connected to the capacitor 362 and a cam follower support bracket 365 via fasteners 368 (e.g., screws). The stand-off member 364 and the inner coupling 366 may be formed of an insulative material.

The cam follower 358 is connected to the cam follower support bracket 365 via one of the fasteners 368. The cam follower 358 may include a bearing (not shown), a roller 372, and/or a rod 374. The bearing may be located within the roller and allow the roller to roll freely on the rod 374. The rod 374 may have a threaded end for attaching to the cam follower support bracket 365. The rod 374 is connected to the cam follower support bracket 365. During operation the rotary motor 352 rotates the cam 356, which causes the roller 372 to move within a slot 376 of the cam 356. This causes the cam follower 358 to move relative to the cam 356 and cause the inner coupling 366 to move in a linear direction, which actuates a rod 380 of the capacitor 362.

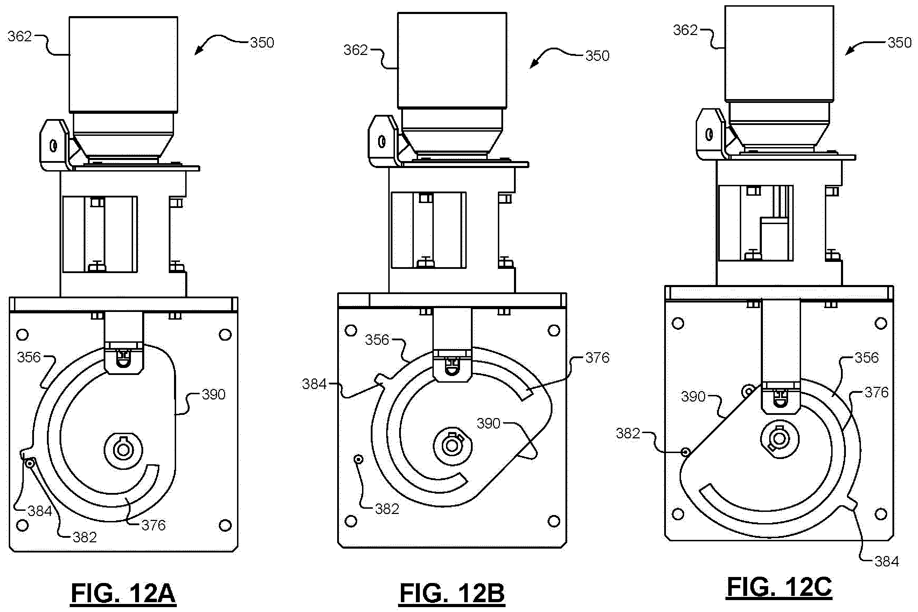

The support bracket 354 includes one or more stops (a single stop 382 is shown), which limit movement of the cam 356 and thus the cam follower 358, the inner coupling 366 and the rod 380. As an example, the one or more stops may be pins, as shown by the stop 382. The stops may be of various types. The cam 356 is shaped and includes a tab 384. The cam 356 may be rotated to a point where the cam 356 and the tab 384 come in contact with the stops. FIGs. 12A-12C illustrate movement of the cam 356 and contacting of a portion (e.g., a surface 390) of the cam 356 and the tab 384 with the stops. FIG. 12A shows the tab 384 in contact with the stop 382 and the cam follower 358 at a first end of the slot 376. FIG. 12B shows the cam 356 transitioning between a first position and a second position. The cam follower 358 is shown at a position between ends of the slot 376. FIG. 12C shows the surface 390 in contact with the stop 382 and the cam follower 358 at a second end of the slot 376.

The stop 382 may be positioned at various positions on the support bracket 354 depending on when the cam is to be prevented from rotating. The stop 382 may be located to prevent the cam follower 358 from coming in contact with an end of the slot 376. Although a single tab 384 is shown, multiple tabs may be included as part of the cam 356.

The slot 376 may have any predetermined pattern, which provides a predetermined path for the cam follower 358 to follow. The pattern of the slot 376 is set to maintain or vary a rate of change of capacitance of the capacitor 362. The slot 376 may have a continuous curvature or may have one or more linear sections. Also, the angular rate of curvature along the slot 376 may vary.

In one embodiment, motion of the cam 356 is controlled to prevent the cam 356 and the tab 384 from contacting the stops. The stops may correspond to movement limits of the rod 380 or may assure that the rod 380 moves within a portion of an overall possible range of movement of the rod 380 relative to the capacitor 362 (or housing of the capacitor 362). For example, the stops may be positioned to limit the rod 380 to movement within a predetermined amount (e.g., 50%) of the overall possible range of movement of the rod 380. This prevents the rod 380 from bottoming out, which minimizes degradation to the capacitor 362.

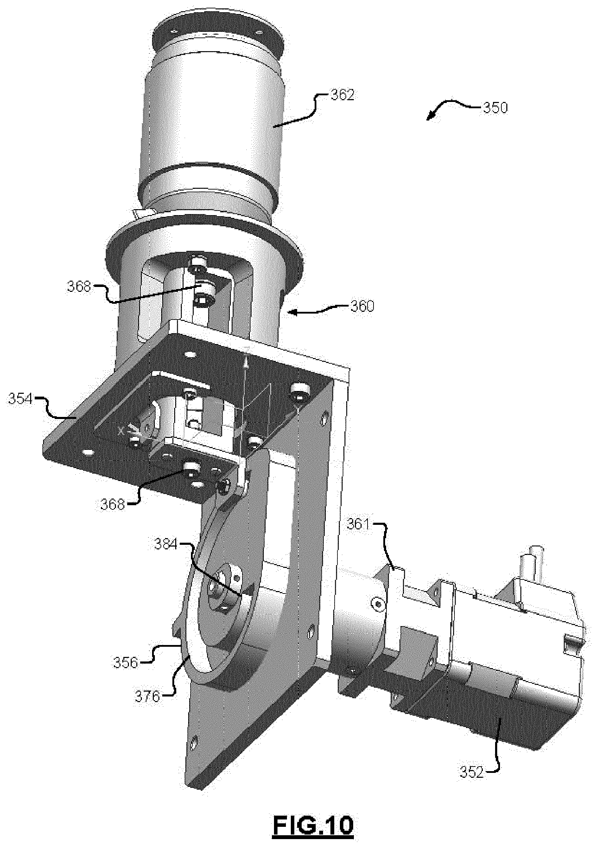

As an example, the cam 356 may be connected to a shaft 392 of the rotary motor 352 and/or a shaft of the gearbox 361 via a clamp 394 and/or a key 396 (the key 396 is shown in FIGs. 10-11, but not FIG. 12). The clamp 394 is connected to the cam 356 and slides over the key 396. The shaft 392 or the shaft of the gearbox 361 is inserted in the key 396. A set screw may be inserted in a side of the key 396 and prevent the key 396 from sliding off of the shaft 392 or the shaft of the gearbox 361. The cam 356 may be connected to the shaft 392 or the shaft of the gearbox 361 using other suitable fasteners and/or techniques. As another example, the cam 356 may be held onto the shaft 392 or the shaft of the gearbox 361 by a screw screwed into an end of the shaft 392 or the shaft of the gearbox 361.

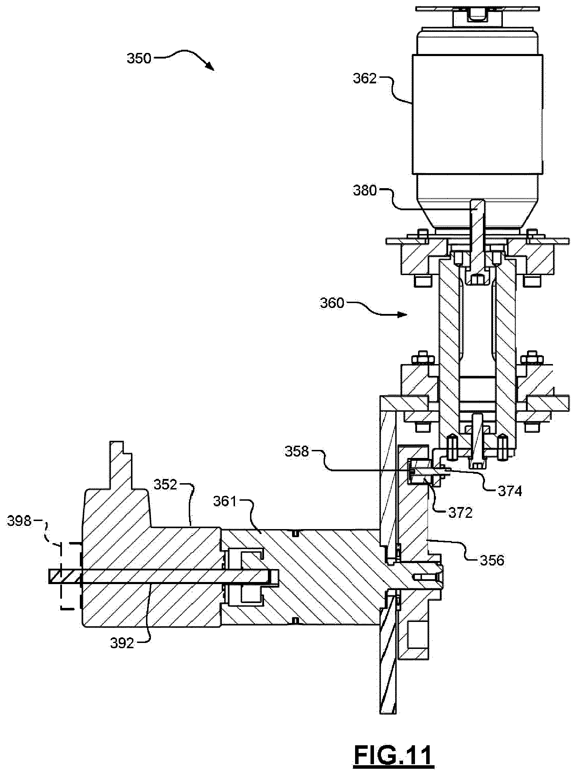

The capacitor system 350 may further include a counterbalance assembly 398, as shown in FIG. 11. The counterbalance assembly 398 may include a spring and/or other components to provide rotational force on the shaft 392 to counterbalance forces on the rod 380 of the capacitor 362. As an example, the spring may be a flat wound coil with an inner end of the coil connected to the shaft 392, such that as the shaft 392 rotates forces in the spring act on the shaft to counterbalance with forces on the rod 380. The counterbalance assembly 398 may provide uniform counterbalance force or non-uniform counterbalance force (increasing or decreasing force) as the shaft is rotated in a single direction. The counterbalance assembly 398 may be configured to counterbalance a predetermined amount (e.g., 90%) of forces exerted on the rod 380 by the capacitor 362.

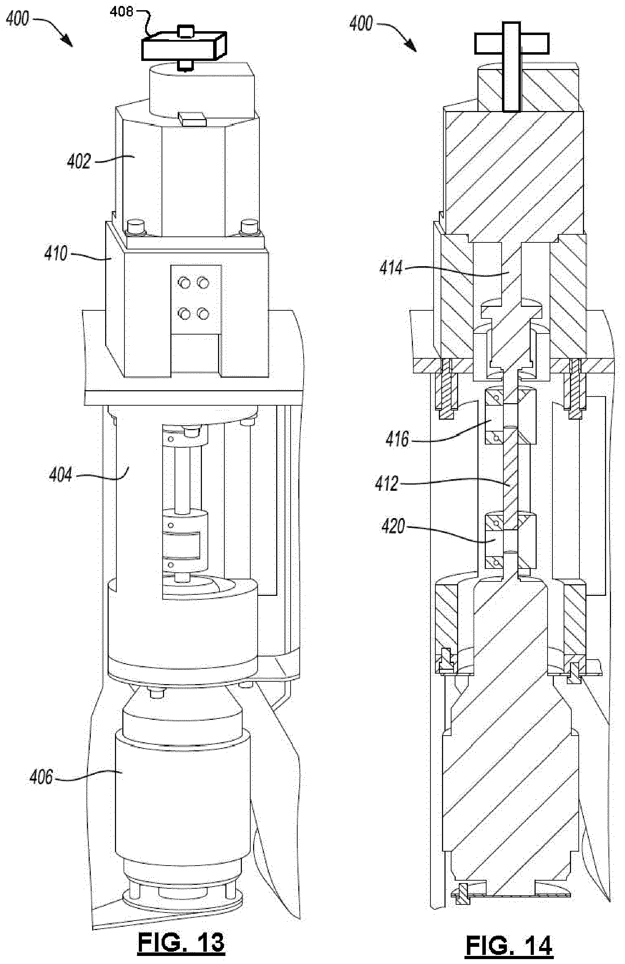

FIGs. 13-14 show a single capacitor system 400 including a single rotary motor 402, a separator support assembly 404, a capacitor 406 and a counterbalance assembly 408. The rotary motor 402 may include a gearbox 410. The rotary motor 402 may operate similarly to the rotary motor 352 of FIGs. 9-12C. The separator support assembly 404 may be configured similarly to the separator support assembly 304 of FIGs. 7-8 or may include an intermediary shaft 412 that is connected to (i) a shaft 414 of the rotary motor 402 via a first flexible coupling 416, and (ii) a leadscrew 418 of the capacitor 406 via a second flexible coupling 420. The counterbalance assembly 404 may be configured similarly to the counterbalance assembly 398 of FIG. 11.

During operation the rotary motor 402 rotates the shaft 414, which rotates the intermediary shaft 412 and the flexible couplings 416, 420. This causes the leadscrew 418 to rotate, which moves a first electrode within the capacitor 406 relative to a second electrode within the capacitor 406. Example electrodes of a capacitor are shown in FIG. 15. The leadscrew may have a high-pitch. As an example, the pitch of the threads of the leadscrew 418 may be, such that the leadscrew 418 has 6 revolutions per inch of travel. As another example, the pitch may be, such that the leadscrew 418 has 4 revolutions per inch of travel. As yet another example, the pitch may be, such that the leadscrew 418 has 3 revolutions per inch of travel. The pitch is higher than a pitch of a traditional vacuum variable capacitor of a plasma processing system, which may have a pitch providing 12 revolutions per inch of travel.

Typically, additional force is needed to rotate the leadscrew 418 due to the increased pitch. However, the counterbalance assembly 408 provides at least some of the increased force needed to rotate the leadscrew 418. The counterbalance assembly 408 provides the increased amount of force and may be configured to counterbalance a predetermined amount (e.g., 90%) of forces exerted on the leadscrew 418 by the capacitor 406. This allows the leadscrew 418 to be rotated with minimal effort while biasing the leadscrew 418. The biased force on the leadscrew 418 causes the leadscrew 418 to rotate without applied force by the rotary motor 402, such that the first electrode moves towards the second electrode.

In another embodiment, the counterbalance assembly 408 is replaced with a second separator support assembly and a second capacitor. The second separator support assembly is connected to the shaft on the opposite side of the rotary motor 402 as the first separator support assembly 404. The second capacitor counterbalances the first capacitor 406. The second separator support assembly may be configured similarly to the first separator support assembly 404. This configuration is similarly to the configuration of FIGs. 5-6, however a rotary motor is used instead of a linear motor and the capacitors include leadscrews and corresponding couplings rather than rods.

FIG. 15 shows an example of a vacuum variable capacitor 500 that includes electrodes 502, 503 having opposing capacitor plate structures including a mounting plate 502b or 503b, respectively. The vacuum variable capacitor 500 is shown as an example; other vacuum variable capacitors may be utilized in the above-described embodiments. The mounting plates have thereon multiple concentric cylindrically-shaped capacitor plates 502a or 503a, respectively. In the following description, the reference numerals 502a and 503a can refer to one or multiple capacitor plates. The electrodes 502 and 503 are positioned with respect to each other to cause capacitor plates 502a of the electrode 502 to fit between adjacent capacitor plates 503a of the electrode 503 (and vice versa), such that a gap exists between adjacent capacitor plates 502a and 503a. The electrodes 502 and 503 provide a capacitance that can be adjusted by moving the electrode 502 relative to the electrode 503.

The electrodes 502 and 503 are positioned in a housing 501. The electrode 503 is attached to the housing 501, such that a position of the electrode 503 remains fixed with respect to the housing 501. The electrode 502 is attached to the housing 501, such that the position of the electrode 502 can move with respect to the housing 501.

An end of a hollow shaft 504 is attached to the, electrode 502. A first member 509 is attached to an end of the shaft 504 opposite the end attached to the electrode 502. A second member (or rod) 505 is attached to (and as shown is screwed) into the first member 509. The second member 505 is attached to a head 508 which is, in turn, attached to the housing 501, such that the head 508 and second member 505 are held in place with respect to the housing 501 along a longitudinal axis 510 of the vacuum variable capacitor 500.

As shown, the electrode 502 may be moved relative to the electrode 503 by rotating the head 508 and/or the second member 505 relative to the first member 509 causing the first member 509 to translate along the longitudinal axis 510. This moves a shaft 504 connected at a first end to the first member 509, which moves the electrode 502 relative to the electrode 503. The shaft 504 is connected at a second end to the first member 509. This threaded configuration may be used in the embodiment of FIGs. 13-14. If the second member 505 is attached to the first member 509 and is not threaded, the second member 505 may be translated without rotation to move the electrode 502 relative to the electrode 503. This non-threaded configuration may be used in the embodiments of FIGs. 5-12.

A bellows 506 surrounds a shaft 504. A bearing 507 enables the shaft 504 to rotate relative to the bellows 506 and the housing 501. The housing 501, bearing 507, bellows 506 and mounting plate 502b form a sealed enclosure, held at a vacuum pressure, within which the capacitor plates 502a and 503a are positioned. The bellows 506 expands and contracts as necessary to allow movement of the threaded member 509, bearing 507, shaft 504 and electrode 502 along the longitudinal axis 510.

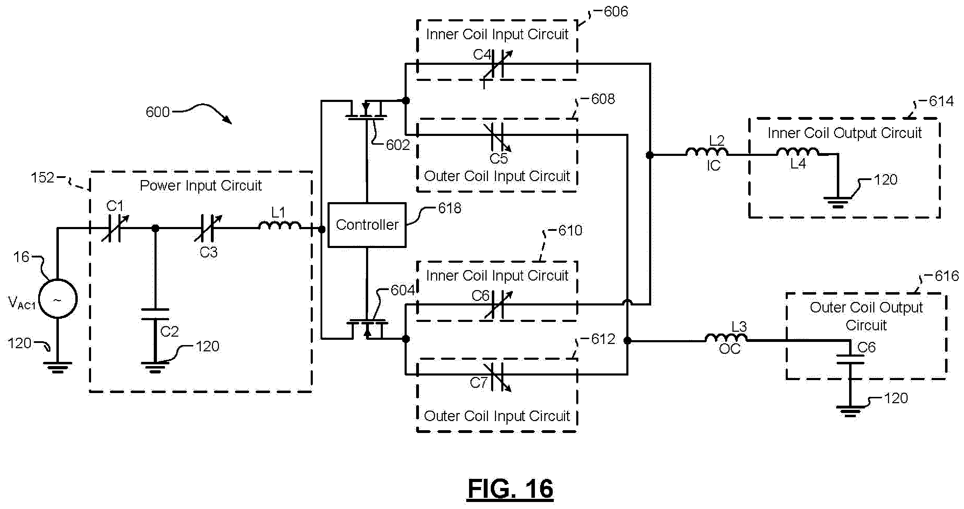

FIG. 16 shows a TCCT match network 600 that receives power from the power source 16. The TCCT match network 600 includes the power input circuit 152, which includes a first capacitor C1, a second capacitor C2, a third capacitor C3 and an inductor L1. The capacitors C1 and C3 may be variable capacitors. The capacitors C1, C3 and inductor L1 are connected in series between the power source 16 and switches 602, 604. The capacitor C2 is connected (i) at a first end to an output of the capacitor C1 and an input of the capacitor C3, and (ii) at a second end to the reference terminal 120. The switches 602, 604 are high-power capable solid-state RF switches. In one embodiment, the switches 602, 604 are silicone carbide (SiC) metal-oxide-semiconductor field-effect transistor (MOSFETs). The first switch 602 is connected between (i) the inductor L1 and (ii) inner coil input circuit 606 and outer coil input circuit 608. The second switch 604 is connected between (i) the inductor L1 and (ii) inner coil input circuit 610 and outer coil input circuit 612.

The inner coil input circuits 606, 610 are connected between the first switch 602 and an inner coil (or inductor) L2. The outer coil input circuits 608, 612 are connected between second switch 604 and an outer coil (or inductor) L3. The inner coil L2 is connected between the inner coil input circuits 606, 610 and an inner coil output circuit 614. The inner coil L3 is connected between the outer coil input circuits 608, 612 and an outer coil output circuit 616.

In operation, the switches 602, 604 receive control signals from a controller 618 or the controller 46 of Fig. 1 if the TCCT match network 600 is implemented in the plasma processing system 10 of FIG. 1. The controller 46 may perform the tasks described herein with respect to the controller 618. The control signals control states of the switches 602, 604 to control whether power is provided to (i) the coil input circuits 606, 608, or (ii) the coil input circuits 610, 612. In one embodiment, the controller 618 rapidly switches between etch and deposition processes, where (i) the switch 602 is ON and power is provided to the coil input circuits 606, 608 during the etch processes, and (ii) the switch 604 is ON and power is provided to the coil input circuits 610, 612 during the deposition processes. During the etch processes, the switch 604 is OFF while the switch 602 is ON. During the deposition processes, the switch 604 is ON while the switch 602 is OFF.

The coil input circuits 606, 608, 610, 612 may respectively include variable capacitors C4, C5, C6, C7, which have respective capacitances. The capacitances of the capacitors C4, C5, C6, C7 may be adjusted between processes and/or during a changeover between recipes. The capacitances of the capacitors C4, C5, C6, C7 may be held at constant values during the processes and/or implementation of the recipes. As an example, the capacitances of capacitors C6, C7 are different than the capacitances of the capacitors C4, C5 to provide different power ratios. The capacitances of the capacitors C4, C5, C6, C7 may be adjusted by the capacitance adjustment system 19 or the controller 46 of FIG. 1 or the controller 618. The capacitors C4, C5, C6, C7 may each be configured for slow or rapid change in capacitance as any of the variable capacitors described and/or disclosed herein.

The inner coil output circuit 614 includes an inductor L4 that is connected in series between the inner coil L2 and ground 120. The outer coil output circuit 616 includes a capacitor C8 that is connected in series between the outer coil L3 and the ground 120.

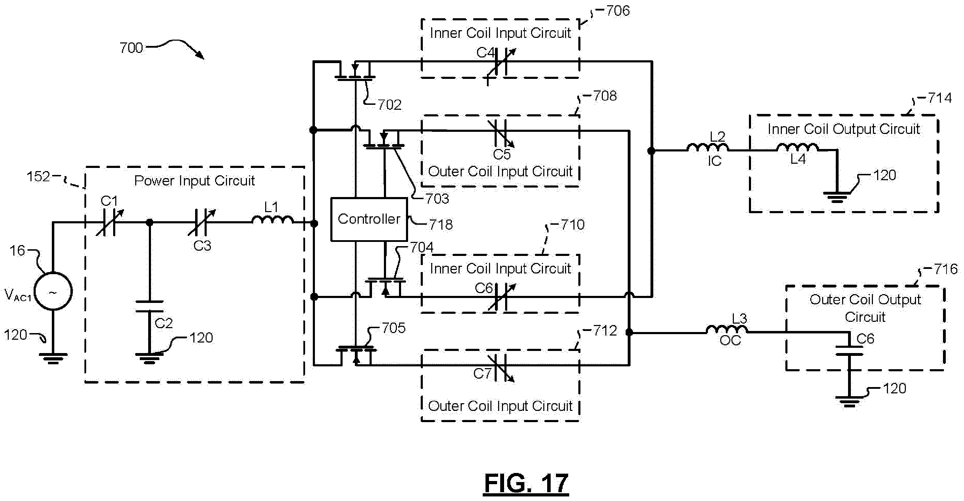

FIG. 17 shows a TCCT match network 700 that receives power from the power source 16. The TCCT match network 700 includes the power input circuit 152, which includes a first capacitor C1, a second capacitor C2, a third capacitor C3 and an inductor L1. The capacitors C1 and C3 may be variable capacitors. The capacitors C1, C3 and inductor L1 are connected in series between the power source 16 and switches 702, 703, 704, 705. The capacitor C2 is connected (i) at a first end to an output of the capacitor C1 and an input of the capacitor C3, and (ii) at a second end to the reference terminal 120. The switches 702, 703, 704, 705 are high-power capable solid-state RF switches. In one embodiment, the switches 602, 604 are SiC MOSFETs. The first switch 702 is connected between the inductor L1 and inner coil input circuit 706. The second switch 703 is connected between the inductor L1 and outer coil input circuit 708. The third switch 704 is connected between the inductor L1 and inner coil input circuit 710. The fourth switch 705 is connected between the inductor L1 and outer coil input circuit 712.

The inner coil input circuit 706 is connected between the first switch 702 and an inner coil (or inductor) L2. The outer coil input circuits 708 is connected between second switch 704 and an outer coil (or inductor) L3. The inner coil input circuit 710 is connected between the third switch 710 and the inner coil L2. The outer coil input circuits 712 is connected between the fourth switch 712 and the outer coil L3. The inner coil L2 is connected between the inner coil input circuits 706, 710 and an inner coil output circuit 714. The inner coil L3 is connected between the outer coil input circuits 708, 712 and an outer coil output circuit 716.

In operation, the switches 702, 703, 704, 705 receive control signals from a controller 718 or the controller 46 of Fig. 1 if the TCCT match network 700 is implemented in the plasma processing system 10 of FIG. 1. The controller 46 may perform the tasks described herein with respect to the controller 718. The control signals control states of the switches 702, 703, 704, 705 to control whether power is provided to (i) the coil input circuits 706, 708, or (ii) the coil input circuits 710, 712. In one embodiment, the controller 718 rapidly switches between etch and deposition processes, where (i) the switches 702, 703 are ON and power is provided to the coil input circuits 706, 708 during the etch processes, and (ii) the switches 704, 705 are ON and power is provided to the coil input circuits 710, 712 during the deposition processes. During the etch processes, the switches 704, 705 are OFF while the switches 702, 703 are ON. During the deposition processes, the switches 704, 705 are ON while the switches 702, 703 are OFF.

The coil input circuits 706, 708, 710, 712 may respectively include variable capacitors C4, C5, C6, C7, which have respective capacitances. The capacitances of the capacitors C4, C5, C6, C7 may be adjusted between processes and/or during a changeover between recipes. The capacitances of the capacitors C4, C5, C6, C7 may be held at constant values during the processes and/or implementation of the recipes. As an example, the capacitances of capacitors C6, C7 are different than the capacitances of the capacitors C4, C5 to provide different power ratios. The capacitances of the capacitors C4, C5, C6, C7 may be adjusted by the capacitance adjustment system 19 or the controller 46 of FIG. 1 or the controller 718. The capacitors C4, C5, C6, C7 may each be configured for slow or rapid change in capacitance as any of the variable capacitors described and/or disclosed herein.

The inner coil output circuit 714 includes an inductor L4 that is connected in series between the inner coil L2 and ground 120. The outer coil output circuit 716 includes a capacitor C8 that is connected in series between the outer coil L3 and the ground 120.

The embodiments of FIGs. 16 and 17 allow for rapid switching between different sets of capacitors (e.g., the set including C4, C5 and the set including C6, C7) for etch and deposition processes without a need for changing a capacitance of one or more capacitors. This allows for rapid switching between power ratios for etch and deposition processes during a RAP without incurring high-cycling between capacitance values of one or more capacitors. The embodiment of FIG. 17 reduces unwanted coupling between antenna circuits (e.g., the inner coil L2 and the outer coil L3) over the embodiment of FIG. 16 by disconnecting unused splitter capacitors (e.g., one of the sets of the capacitors C4, C5 and C6, C7).

The foregoing description is merely illustrative in nature and is in no way intended to limit the disclosure, its application, or uses. The broad teachings of the disclosure can be implemented in a variety of forms. Therefore, while this disclosure includes particular examples, the true scope of the disclosure should not be so limited since other modifications will become apparent upon a study of the drawings, the specification, and the following claims. It should be understood that one or more steps within a method may be executed in different order (or concurrently) without altering the principles of the present disclosure. Further, although each of the embodiments is described above as having certain features, any one or more of those features described with respect to any embodiment of the disclosure can be implemented in and/or combined with features of any of the other embodiments, even if that combination is not explicitly described. In other words, the described embodiments are not mutually exclusive, and permutations of one or more embodiments with one another remain within the scope of this disclosure.

Spatial and functional relationships between elements (for example, between modules, circuit elements, semiconductor layers, etc.) are described using various terms, including "connected," "engaged," "coupled," "adjacent," "next to," "on top of," "above," "below," and "disposed." Unless explicitly described as being "direct," when a relationship between first and second elements is described in the above disclosure, that relationship can be a direct relationship where no other intervening elements are present between the first and second elements, but can also be an indirect relationship where one or more intervening elements are present (either spatially or functionally) between the first and second elements. As used herein, the phrase at least one of A, B, and C should be construed to mean a logical (A OR B OR C), using a non-exclusive logical OR, and should not be construed to mean "at least one of A, at least one of B, and at least one of C."

In some implementations, a controller is part of a system, which may be part of the above-described examples. Such systems can comprise semiconductor processing equipment, including a processing tool or tools, chamber or chambers, a platform or platforms for processing, and/or specific processing components (a wafer pedestal, a gas flow system, etc.). These systems may be integrated with electronics for controlling their operation before, during, and after processing of a semiconductor wafer or substrate. The electronics may be referred to as the "controller," which may control various components or subparts of the system or systems. The controller, depending on the processing requirements and/or the type of system, may be programmed to control any of the processes disclosed herein, including the delivery of processing gases, temperature settings (e.g., heating and/or cooling), pressure settings, vacuum settings, power settings, radio frequency (RF) generator settings, RF matching circuit settings, frequency settings, flow rate settings, fluid delivery settings, positional and operation settings, wafer transfers into and out of a tool and other transfer tools and/or load locks connected to or interfaced with a specific system.

Broadly speaking, the controller may be defined as electronics having various integrated circuits, logic, memory, and/or software that receive instructions, issue instructions, control operation, enable cleaning operations, enable endpoint measurements, and the like. The integrated circuits may include chips in the form of firmware that store program instructions, digital signal processors (DSPs), chips defined as application specific integrated circuits (ASICs), and/or one or more microprocessors, or microcontrollers that execute program instructions (e.g., software). Program instructions may be instructions communicated to the controller in the form of various individual settings (or program files), defining operational parameters for carrying out a particular process on or for a semiconductor wafer or to a system. The operational parameters may, in some embodiments, be part of a recipe defined by process engineers to accomplish one or more processing steps during the fabrication of one or more layers, materials, metals, oxides, silicon, silicon dioxide, surfaces, circuits, and/or dies of a wafer.

The controller, in some implementations, may be a part of or coupled to a computer that is integrated with the system, coupled to the system, otherwise networked to the system, or a combination thereof. For example, the controller may be in the "cloud" or all or a part of a fab host computer system, which can allow for remote access of the wafer processing. The computer may enable remote access to the system to monitor current progress of fabrication operations, examine a history of past fabrication operations, examine trends or performance metrics from a plurality of fabrication operations, to change parameters of current processing, to set processing steps to follow a current processing, or to start a new process. In some examples, a remote computer (e.g. a server) can provide process recipes to a system over a network, which may include a local network or the Internet. The remote computer may include a user interface that enables entry or programming of parameters and/or settings, which are then communicated to the system from the remote computer. In some examples, the controller receives instructions in the form of data, which specify parameters for each of the processing steps to be performed during one or more operations. It should be understood that the parameters may be specific to the type of process to be performed and the type of tool that the controller is configured to interface with or control. Thus as described above, the controller may be distributed, such as by comprising one or more discrete controllers that are networked together and working towards a common purpose, such as the processes and controls described herein. An example of a distributed controller for such purposes would be one or more integrated circuits on a chamber in communication with one or more integrated circuits located remotely (such as at the platform level or as part of a remote computer) that combine to control a process on the chamber.

Without limitation, example systems may include a plasma etch chamber or module, a deposition chamber or module, a spin-rinse chamber or module, a metal plating chamber or module, a clean chamber or module, a bevel edge etch chamber or module, a physical vapor deposition (PVD) chamber or module, a chemical vapor deposition (CVD) chamber or module, an atomic layer deposition (ALD) chamber or module, an atomic layer etch (ALE) chamber or module, an ion implantation chamber or module, a track chamber or module, and any other semiconductor processing systems that may be associated or used in the fabrication and/or manufacturing of semiconductor wafers.

As noted above, depending on the process step or steps to be performed by the tool, the controller might communicate with one or more of other tool circuits or modules, other tool components, cluster tools, other tool interfaces, adjacent tools, neighboring tools, tools located throughout a factory, a main computer, another controller, or tools used in material transport that bring containers of wafers to and from tool locations and/or load ports in a semiconductor manufacturing factory.

## Claims

1. A system comprising:
a first linear motor comprising a shaft that is linearly driven based on a current supplied to the first linear motor;
a first separator support assembly configured to connect to the shaft of the first linear motor and to a rod of a first capacitor of a match network,
wherein the first linear motor is configured to actuate the rod to move a first electrode of the first capacitor relative to a second electrode of the first capacitor to change a capacitance of the first capacitor; and
a controller connected to the first linear motor and configured to adjust power supplied to a first radio frequency reactor coil of a plasma processing chamber by adjusting the current supplied to the first linear motor.

2. The system of claim 1, further comprising:
the match network comprising the first capacitor, wherein the match network is configured to receive a radio frequency signal from a power source; and
the first radio frequency reactor coil configured to receive the radio frequency signal from the match network and transmit the radio frequency signal into the plasma processing chamber based on the capacitance of the first capacitor, or
further comprising a second separator support assembly configured to connect to the shaft of the first linear motor and to a second rod of a second capacitor of the match network, wherein:
the first linear motor is configured to actuate the second rod to move a first electrode of the second capacitor relative to a second electrode of the second capacitor to change a capacitance of the second capacitor; and
the controller is configured to adjust power supplied to a second radio frequency reactor coil of the plasma processing chamber by adjusting the current supplied to the first linear motor.

3. The system of claim 2, wherein:
the controller is configured to iteratively switch between a first radio frequency power ratio and a second radio frequency power ratio by adjusting the current supplied to the first linear motor; and
the first radio frequency power ratio and the second radio frequency power ratio are ratios of an amount of power supplied to the first radio frequency reactor coil relative to an amount of power supplied to the second radio frequency reactor coil.

4. The system of claim 3, wherein the controller is configured to:
select the first radio frequency power ratio for etch processing;
select the second radio frequency power ratio for deposition processing; and
iteratively switch between (i) performing a selected one of a plurality of etch processes and (ii) performing a selected one of a plurality of deposition processes, wherein performance of each of the plurality of etch processes includes etch processing, and wherein performance of each of the plurality of deposition processes includes deposition processing.

5. The system of claim 2, further comprising:
the first capacitor; and
the second capacitor, wherein the second capacitor counterbalances a force exerted on the shaft of the first linear motor by the first capacitor.

6. The system of claim 1, further comprising:
a second linear motor comprising a shaft that is linearly driven based on a current supplied to the second linear motor; and
a second separator support assembly configured to connect to the shaft of the second linear motor and to a second rod of a second capacitor of the match network,
wherein
the second linear motor is configured to actuate the second rod to move a first electrode of the second capacitor relative to a second electrode of the second capacitor to change a capacitance of the second capacitor,
the controller is connected to the second linear motor and configured to adjust power supplied to a second radio frequency reactor coil of the plasma processing chamber by adjusting the current supplied to the second linear motor.

7. The system of claim 6, wherein:
the controller is configured to iteratively switch between a first radio frequency power ratio and a second radio frequency power ratio by adjusting the current supplied to the first linear motor and the current supplied to the second linear motor; and
the first radio frequency power ratio and the second radio frequency power ratio are ratios of an amount of power supplied to the first radio frequency reactor coil relative to an amount of power supplied to the second radio frequency reactor coil; or
the system is further comprising the first radio frequency reactor coil and the second radio frequency reactor coil.

8. The system of claim 1, further comprising a counterbalance assembly connected to the first linear motor and configured to counterbalance forces exerted on the shaft by the first capacitor.

9. The system of claim 8, wherein:
the first capacitor is a variable vacuum capacitor; and
the first capacitor resists movement of the first electrode away from the second electrode and in a direction away from the first linear motor.

10. A system comprising:
a first cam follower;
a first cam comprising a slot, wherein the slot has a predetermined path, and wherein the first cam follower is disposed at least partially within the slot and follows the predetermined path;
a first rotary motor connected to the first cam and configured to be driven based on a current supplied to the first rotary motor, wherein the first rotary motor is configured to rotate the first cam causing the first cam follower to move along the predetermined path;
a first separator support assembly configured to connect to the first cam follower and a rod of a first capacitor of a match network,
wherein rotation of the cam and movement of the cam follower actuates the rod and moves a first electrode relative to a second electrode of the first capacitor to change a capacitance of the first capacitor; and
a controller connected to the first rotary motor and configured to adjust power supplied to a first radio frequency reactor coil of a plasma processing chamber by adjusting the current supplied to the first rotary motor.

11. The system of claim 10, wherein:
the first rotary motor comprises a shaft;
the shaft is connected to the first cam; and
the rotary motor is configured to rotate the shaft causing the first cam to rotate and the first cam follower to move along the predetermined path; or
wherein:
the first cam is connected to a support bracket; and
the first cam is configured to rotate relative to the support bracket; or
wherein:
the first cam is connected to a support bracket; and
the first cam is configured to rotate relative to the support bracket
wherein the support bracket comprises a stop element; and
the first cam is prevented from rotating in a predetermined direction when the first cam is in contact with the stop element, or
wherein:
the first cam is connected to a support bracket; and
the first cam is configured to rotate relative to the support bracket
wherein the support bracket comprises a first stop element;
the first cam comprises a second stop element; and
the first cam is prevented from rotating in a predetermined direction when the second stop element of the first cam is in contact with the first stop element of the support bracket; or
the system is further comprising a counterbalance assembly connected to the rotary motor or the cam and configured to counterbalance resistance of movement of the first electrode, or
the system is further comprising:
a second cam follower;
a second cam comprising a slot, wherein the slot of the second cam has a second predetermined path, and wherein the second cam follower is disposed at least partially within the slot of the second cam and follows the second predetermined path;
a second rotary motor connected to the second cam and configured to be driven based on a current supplied to the second rotary motor, wherein the second rotary motor is configured to rotate the second cam causing the second cam follower to move along the second predetermined path; and
a second separator support assembly configured to connect to the second cam follower and a rod of a second capacitor of the match network,
wherein rotation of the second cam and movement of the second cam follower actuates the rod of the second capacitor and moves the first electrode of the second capacitor relative to a second electrode of the second capacitor to change a capacitance of the second capacitor, and
wherein the controller is connected to the second rotary motor and is configured to adjust power supplied to a second radio frequency reactor coil of the plasma processing chamber by adjusting the current supplied to the second rotary motor.

12. A system comprising:
a leadscrew connected to a first electrode of a first capacitor of a match network;
a first rotary motor connected to and configured to rotate the leadscrew based on a current supplied to the first rotary motor;
a first separator support assembly configured to connect to the leadscrew and to a shaft of the first rotary motor,
wherein the first rotary motor is configured to rotate the leadscrew to move the first electrode relative to a second electrode of the first capacitor to change a capacitance of the first capacitor;
a counterbalance assembly connected to the shaft of the first rotary motor and configured to counterbalance forces on the leadscrew by the first capacitor; and
a controller connected to the first rotary motor and configured to adjust power supplied to a first radio frequency reactor coil of a plasma processing chamber by adjusting the current supplied to the first rotary motor.

13. The system of claim 12, further comprising a second separator support assembly configured to connect to the shaft of the first rotary motor and to a second leadscrew of a second capacitor of the match network, wherein:
the first rotary motor is configured to move a first electrode of the second capacitor relative to a second electrode of the second capacitor to change a capacitance of the second capacitor; and
wherein the controller is configured to adjust power supplied to a second radio frequency reactor coil of the plasma processing chamber by adjusting the current supplied to the first rotary motor; or
the system is further comprising:
a second leadscrew;
a second rotary motor connected to and configured to rotate the second leadscrew based on a current supplied to the second rotary motor;
a second separator support assembly configured to connect to the second leadscrew and to a second shaft of the second rotary motor,
wherein the second rotary motor is configured to move a first electrode of a second capacitor of the match network relative to a second electrode of the second capacitor to change a capacitance of the second capacitor; and
a second counterbalance assembly connected to the second rotary motor and configured to counterbalance forces on the second shaft by the second capacitor,
wherein
the second rotary motor is configured to move the first electrode of the second capacitor relative to a second electrode of the second capacitor to change a capacitance of the second capacitor, and
the controller is connected to the second rotary motor and configured to adjust power supplied to a second radio frequency reactor coil of the plasma processing chamber by adjusting the current supplied to the second rotary motor.

14. A system comprising:
a match network comprising a first capacitor, a second capacitor, a third capacitor, and a fourth capacitor;
a first one or more switches configured to supply power from a power input circuit to the first capacitor and the second capacitor;
a second one or more switches configured to supply power from the power input circuit to the third capacitor and the fourth capacitor; and
a controller configured to (i) control states of the first one or more switches and the second one or more switches to switch between providing a first ratio of power and a second ratio of power, (ii) provide the first ratio of power to a first radio frequency reactor coil and a second radio frequency reactor coil of a plasma processing chamber by activating the first one or more switches, and (iii) provide the second ratio of power to the first radio frequency reactor coil and the second radio frequency reactor coil by activating the second one or more switches.

15. The system of claim 14, wherein:
the first one or more switches comprises only a first switch configured to supply power from the power input circuit to the first capacitor and the second capacitor; and
the second one or more switches comprises only a second switch configured to supply power from the power input circuit to the third capacitor and the fourth capacitor; or wherein:
the first one or more switches comprise a first switch and a second switch;
the first switch supplies power from the power input circuit to the first capacitor;
the second switch supplies power from the power input circuit to the second capacitor;
the second one or more switches comprise a third switch and a fourth switch;
the third switch supplies power from the power input circuit to the third capacitor; and
the fourth switch supplies power from the power input circuit to the fourth capacitor; or
wherein the controller is configured to:
activate the first one or more switches during etch processing;
activate the second one or more switches during deposition processing; and
iteratively switch between (i) performing a selected one of a plurality of etch processes and (ii) performing a selected one of a plurality of deposition processes, wherein performance of each of the plurality of etch processes includes etch processing, and wherein performance of each of the plurality of deposition processes includes deposition processing; or
the system further comprising:
an inner coil output circuit comprising an inductor connected (i) at a first end to the first radio frequency reactor coil, and (ii) at a second end to a reference terminal; and
an outer coil output circuit comprising a fifth capacitor connected (i) at a first end to the second radio frequency reactor coil,
wherein
a first end of the first radio frequency reactor coil is connected to the first capacitor and the third capacitor,
a second end of the first radio frequency reactor coil is connected to the inner coil output circuit;
a first end of the second radio frequency reactor coil is connected to the second capacitor and the fourth capacitor; and
the second end of the second radio frequency reactor coil is connected to the outer coil output circuit.
